# EUROPEAN PATENT APPLICATION

(11) **EP 2 552 043 A1**
(43) Date of publication of application: **30.01.2013**
(21) Application number: 11006087.8
(22) Date of filing: 25.07.2011
(51) Int. Cl.: H04L 1/06, H04L 1/00

(54) **Spatial multiplexing for bit-interleaved coding and modulation with quasi-cyclic LDPC codes**

(71) Applicant: Panasonic Corporation, Kadoma-shi Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to bit interleaving and de-interleaving of quasi-cyclic low-density parity-check (QC-LDPC) codes for a communication system with spatial multiplexing over a plurality of transmit antennas and discloses a bit interleaver and a corresponding method that achieves optimum diversity and allows for a particularly efficient hardware implementation due to its high degree of parallelism. To this end, a permutation for mapping the bits of the QC-LDPC codeword to a sequence of constellation words is constructed such that (i) each constellation word is made up of bits from Bt/2 different cyclic blocks of the codeword, Bt being the number of bits of the constellation word, (ii) each pair of constellation word bits that have the same robustness is made up of bits from the same cyclic block, and (iii) constellation words for different antennas are made up of bits from different cyclic blocks.

## Description

The present invention relates to the field of digital communications, and more specifically to bit interleavers and de-interleavers for bit-interleaved coding and modulation systems with quasi-cyclic low-density parity-check codes, QAM modulation and spatial multiplexing for multiple transmit antennas, as well as to corresponding methods, transmitters, and receivers.

### BACKGROUND OF THE INVENTION

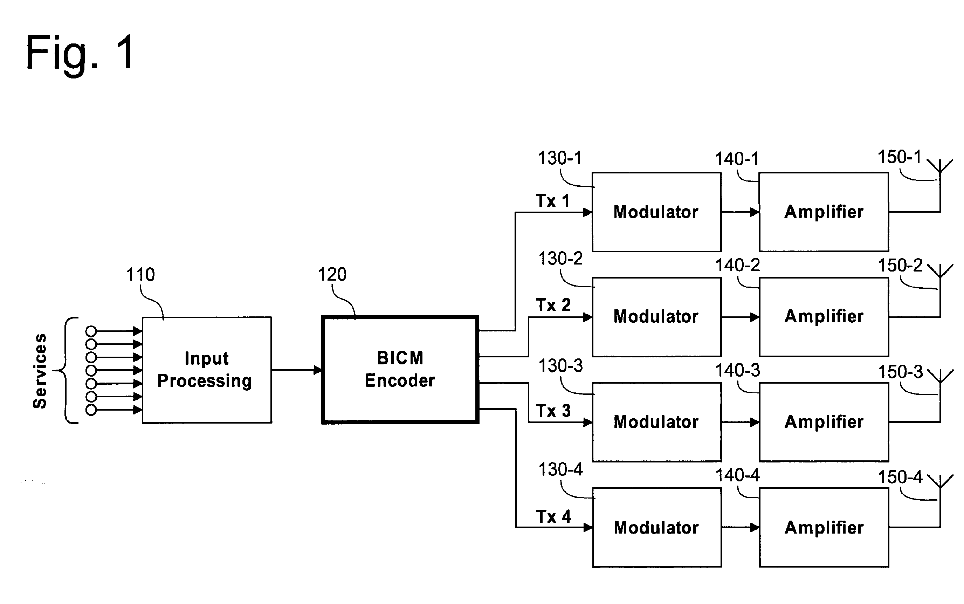

Figure 1 is a block diagram of a transmitter-side communication chain involving bit-interleaved coding and modulation (BICM) with spatial multiplexing over multiple antennas (150-1, ..., 150-4). The input processing unit (110) formats the input bitstreams into blocks of a predetermined length, called base-band frames. The BICM encoder (120) converts the base-band frames into a plurality of data streams consisting of complex symbols, the number of data streams being equal to the number of antennas. Each stream is further processed by a modulation chain, which comprises at least a modulator (130-1, ..., 130-4), e.g. orthogonal frequency-division multiplexing OFDM, and a power amplifier (140-1, ..., 140-4).

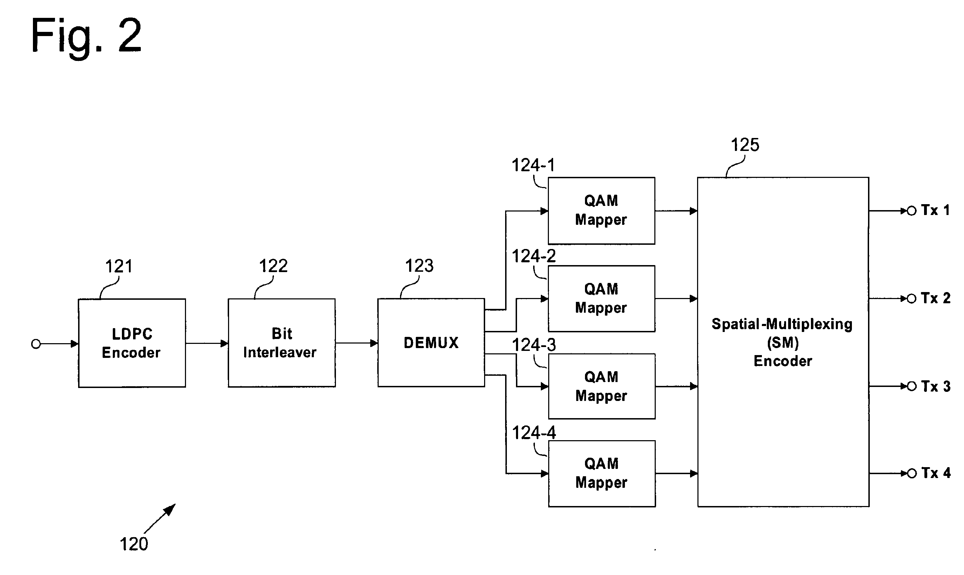

Figure 2 is a block diagram of a bit-interleaved coding and modulation encoder (120) for spatial multiplexing. The input blocks, i.e. base-band frames, are encoded by the low-density parity-check code (LDPC) encoder (121) and fed to bit interleaver (122). The LDPC encoded and interleaved data block is demultiplexed into a plurality of bit streams by demultiplexer (123). The bit streams are then mapped to complex symbols by a constellation mapper (124-1, ..., 124-4), which employs e.g. quadrature amplitude modulation QAM, and fed through an optional spatial-multiplexing encoder (125). The spatial-multiplexing encoder (125) typically provides for multiplying the vector of input signals by an orthogonal square matrix.

An LDPC code is a linear error-correcting code that is fully defined by its parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more folded diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementation.

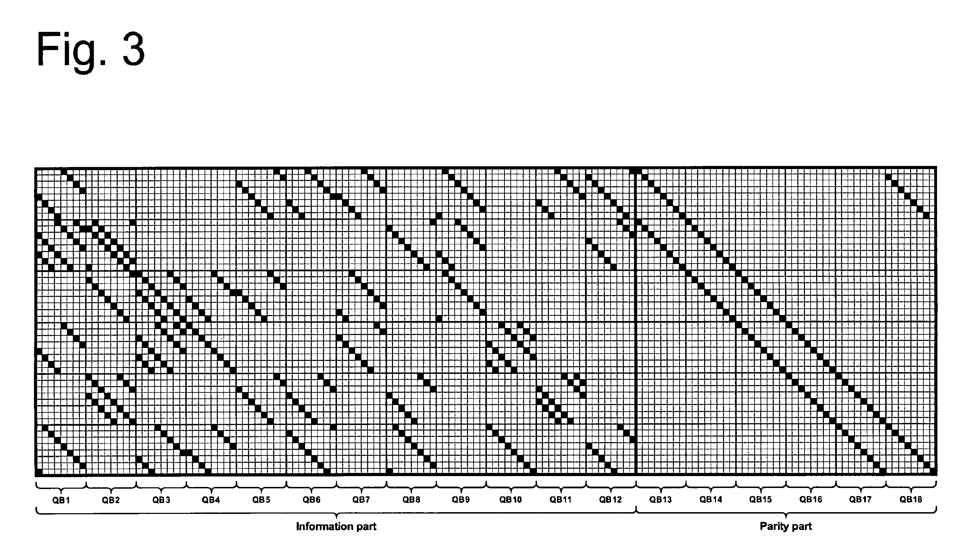

Figure 3 shows the PCM of an example LDPC code with cyclic factor Q=8, the PCM having circulants with one or two diagonals. This code encodes a block of 8x12=96 bits to a codeword of 8x16=128 bits, having therefore a code rate of 2/3. The codeword bits are subdivided into blocks of Q bits, which will be referred to as cyclic blocks and denoted by QB throughout this document.

The code in Figure 3 belongs to a special family of QC LDPC codes are the repeat-accumulate (RA) QC LDPC codes. These codes are well known for their ease of encoding and are encountered in a large number of standards, such as the second-generation DVB standards: DVB-S2, DVB-T2, and DVB-C2. The right-hand side part of the PCM, which corresponds to the parity bits, has a staircase structure.

Typically, the bits of an LDPC codeword have different importance levels, and the bits of a constellation have different robustness levels. A direct, i.e. non-interleaved, mapping of the LDPC codeword bits to the constellation bits leads to a suboptimal performance. That is why the codeword bits need to be interleaved prior to being mapped onto constellations.

For this purpose, a bit interleaver 122 is used between the LDPC encoder 121 and the constellation mappers 124-1 through 124-4, as illustrated in Figure 2. By carefully designing the interleaver, an optimal association can be achieved between the bits of the LDPC codeword and the bits encoded by the constellation, which leads to an improved performance. A typical measure of the performance is the bit-error rate (BER) as a function of the signal-to-noise ratio (SNR).

The different importance levels of the bits of an LDPC codeword result primarily from the fact that not all the bits are involved in the same number of parity checks. The more parity checks (check nodes) a codeword bit (variable node) is involved in, the more important that bit is in the iterative LDPC decoding process. A further reason is the fact that the variable nodes have different connectivities to the cycles in the Tanner graph representation of the LDPC code, so they may have different importance levels even when they are involved in the same number of parity checks. These aspects are well understood in the art. As a general rule, the importance level of a variable node increases with the number of check nodes it is connected to.

In the particular case of quasi-cyclic LDPC codes, all bits in a cyclic block of Q bits have the same importance since all of them are involved in the same number of parity checks and have the same connectivity to the cycles in the Tanner graph.

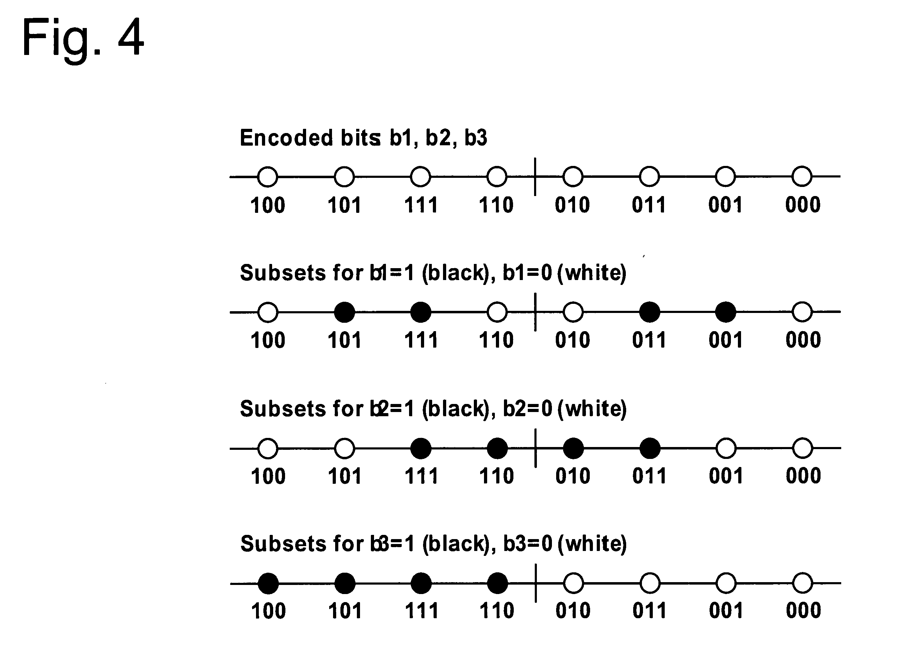

Likewise, the different robustness levels of the bits encoded in a constellation are a well known fact. For instance, a complex quadrature amplitude modulation (QAM) constellation consists of two independent pulse amplitude modulation (PAM) symbols, one for the real part and one for the imaginary part. For rectangular constellations each of the two PAM symbols encodes the same number of bits. The bits encoded in a PAM symbol have different robustness levels, as shown in Figure 4 for an 8-PAM symbol with Gray encoding. The different robustness levels result from the fact that the distance between the two subsets defined by a bit (0 or 1) is different for each bit. The larger the distance, the more robust or reliable the bit. In Figure 4, bit b3 is the most robust, whereas bit b1 is the least robust.

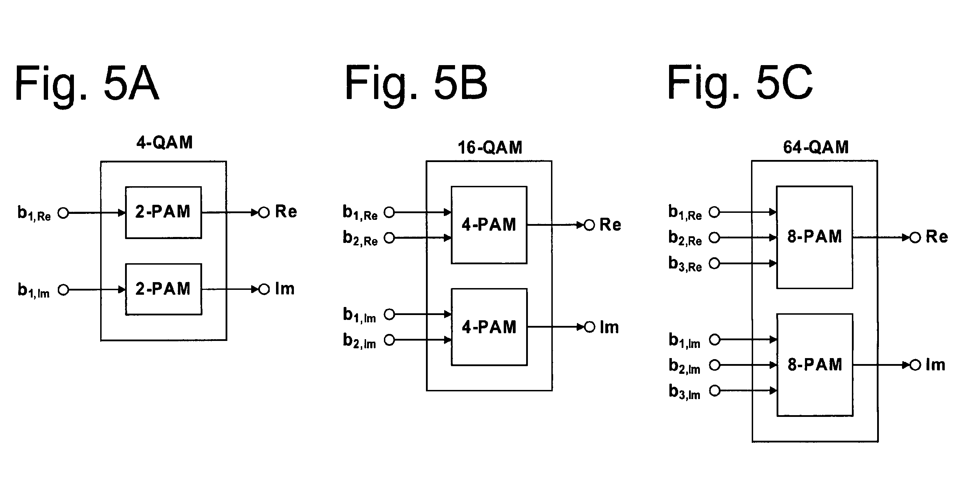

The most common QAM constellations are illustrated in Figures 5A to 5C. Figure 5A shows a blockdiagram of a 4-QAM (QPSK) constellation mapper that encodes two bits and has one robustness level; Figure 5B shows a blockdiagram of a 16-QAM constellation mapper that encodes four bits and has two robustness levels; and Figure 5C shows a blockdiagram of a 64-QAM constellation mapper that encodes six bits and has three robustness levels.

In a spatial-multiplexing system with T transmit antennas, T QAM complex symbols are transmitted in the same channel slot. For OFDM modulation a channel slot is represented by an OFDM cell, which is a subcarrier in an OFDM symbol. The T QAM symbols, which are not necessarily of the same size, form a spatial-multiplexing (SM) block.

The T QAM symbols in an SM block can be transmitted uncoded, i.e. each over its own antenna, or an additional encoding step can be applied, as shown in Figure 2 (spatial-multiplexing encoder 125), whereby T QAM symbols are jointly encoded. The encoding typically consists in multiplying the vector of 2T real components by an orthogonal square matrix. In the most general case, the encoding can be applied over multiple K channel slots, i.e. to KT QAM symbols, which exploits the additional time and/or frequency diversity available over the K channel slots.

Throughout this document, the number of bits transmitted in a channel slot is denoted by B and the number of bits in each QAM symbol by Bt, where t is the antenna index between 1 and T.

### SUMMARY OF THE INVENTION

It is an object of the present invention to improve the performance of communication systems that employ spatial multiplexing and quasi-cyclic LDPC codes. It is a further object of the present invention to provide a bit interleaver and a corresponding method that are specifically optimized for quasi-cyclic LDPC codes and square QAM constellations.

This is achieved by the features as set forth in the independent claims.

Preferred embodiments are the subject matter of dependent claims.

It is the particular approach of the present invention to map the bits of an LDPC codeword to the constellation word bits such that (i) each constellation word is made up of bits from Bt/2 different cyclic blocks of the codeword, Bt being the number of bits of the constellation word, (ii) each pair of constellation word bits that have the same robustness is made up of bits from the same cyclic block, and (iii) constellation words for different transmit antennas are made up of bits from different cyclic blocks.

According to a first aspect of the present invention, a method for bit interleaving in a communication system with spatial multiplexing over T transmit antennas, T being an integer greater than 1, employing quasi-cyclic low-density parity-check codes, is provided. The method comprises the steps of receiving a codeword of the quasi-cyclic low-density parity-check code, the codeword consisting of N cyclic blocks, each cyclic block consisting of Q bits; applying a bit permutation to the bits of the codeword; dividing the permuted codeword into a plurality of spatial-multiplexing blocks, each spatial-multiplexing block consisting of B bits partitioned into T constellation words, one for each transmit antenna, each constellation word indicating one of a plurality of predefined constellation points, the bits of each constellation word being divisible into pairs of bits having the same robustness, and is characterized in that the bit permutation is adapted such that there is at least one spatial-multiplexing block that is made up of bits from B/2 different cyclic-blocks; and each constellation word of the at least one spatial-multiplexing block is made up of bits from Bt/2 different cyclic blocks, Bt being the number of bits of the constellation word, wherein each of the bit pairs of the constellation word is made up of bits from a common one of the Bt/2 different cyclic blocks.

According to a second aspect of the present invention, a method for bit de-interleaving in a communication system with spatial multiplexing over T transmit antennas employing quasi-cyclic low-density parity-check codes, T being an integer greater than 1, is provided. The method comprises the steps of receiving a plurality of spatial-multiplexing blocks, each spatial-multiplexing block consisting of B bits partitioned into T constellation words; multiplexing the received plurality of spatial-multiplexing blocks into a bit string; and applying an inverse bit permutation to the bits of the bit string in order to recover a codeword of the quasi-cyclic low-density parity-check code, wherein the inverse bit permutation is adapted for reverting the bit permutation performed by the bit interleaving method according to the first aspect of the invention.

According to a third aspect of the present invention, a bit interleaver for a communication system with spatial multiplexing over T transmit antennas, T being an integer greater than 1, employing quasi-cyclic low-density parity-check codes is provided. The bit interleaver comprises a bit permutation unit adapted for receiving a codeword of the quasi-cyclic low-density parity-check code, the codeword consisting of N cyclic blocks, each cyclic block consisting of Q bits, for applying a bit permutation to the bits of the codeword, and for dividing the permuted codeword into a plurality of spatial-multiplexing blocks, each spatial-multiplexing block consisting of B bits partitioned into T constellation words, one for each transmit antenna, each constellation word indicating one of a plurality of predefined constellation points, the bits of each constellation word being divisible into pairs of bits having the same robustness, and is characterized in that the bit permutation is adapted such that there is at least one spatial-multiplexing block that is made up of bits from B/2 different cyclic-blocks; and each constellation word of the at least one spatial-multiplexing block is made up of bits from Bt/2 different cyclic blocks, Bt being the number of bits of the constellation word, wherein each of the bit pairs of the constellation word is made up of bits from a common one of the Bt/2 different cyclic blocks.

According to a fourth aspect of the present invention, a bit de-interleaver for a communication system with spatial multiplexing over T transmit antennas employing quasi-cyclic low-density parity-check codes, T being an integer greater than 1, is provided. Thebit de-interleaver comprises a bit permutation unit adapted for receiving a plurality of spatial-multiplexing blocks, each spatial-multiplexing block consisting of B bits partitioned into T constellation words, for multiplexing the received plurality of spatial-multiplexing blocks into a bit string, and for applying an inverse bit permutation to the bits of the bit string in order to recover a codeword of the quasi-cyclic low-density parity-check code, wherein the inverse bit permutation is adapted for reverting the bit permutation performed by the bit interleaver according to the third aspect of the invention.

According to a fifth aspect of the present invention, a transmitter for a communication system with spatial multiplexing over multiple antennas employing quasi-cyclic low-density parity-check codes is provided. The transmitter comprises an encoder for encoding input data by means of a low-density parity check code; a bit interleaver according to the third aspect of the present invention for bit interleaving the bits of a codeword generated by the encoder and for mapping the interleaved bits to a plurality of constellation words; and a plurality of constellation mappers, each for mapping a constellation word of the plurality of constellation words to a complex symbol that is to be transmitted by a corresponding one of a plurality of transmit antennas.

According to a sixth aspect of the present invention, a receiver for a communication system with spatial multiplexing over multiple antennas employing quasi-cyclic low-density parity-check codes is provided. The transmitter comprises a mulitple-input multiple-output decoder for converting signals from a plurality of receive antennas into a plurality of constellation words, one for each transmit antenna; a mulitplexer for mapping the bits of the constellation words to a bit string; a bit de-interleaver according to the fourth aspect of the present invention for de-interleaving the bits of the bit string in order to recover a codeword of the the low-density parity check code; and a decoder for decoding the recovered codeword.

According to a preferred embodiment, the codeword is divided into a plurality of sections such that either each section comprises B/2 cyclic blocks or one of the sections comprises less than B/2 cyclic blocks and each of the other sections comprises B/2 cyclic blocks; wherein the bit permutation is adapted such that each spatial-multiplexing block is made up of bits from one section only. In this manner, the step of applying the bit permutation may be performed by applying a section permutation to the bits of each section independently of the other sections. This results in a configuration that lends itself to a hardware or software implementation with a high degree of parallelism.

Preferably, the bit permutation is adapted such that all Q bits of a cyclic group are mapped to bits of the same robustness. In this manner, codeword bits having the same importance are mapped to constellation bits having the same robustness. This is clearly advantageous, because the importance and the robustness may be matched. For example, the most important codeword bits may be mapped to the most robust constellation bits, and the least important codeword bits may be mapped to the least robust constellation bits, and so forth.

In a particularly important application example, the predefined constellation points represent square QAM constellations. Square QAM constellations allow for a particularly simple encoding and decoding. Moreover, with square QAM constellations, the bits of a constellation word have pairwise the same robustness.

The above and other objects and features of the present invention will become more apparent from the following description and preferred embodiments given in conjunction with the accompanying drawings, in which:
- Fig. 1: is a block diagram of a transmitter-side communication chain involving bit-interleaved coding and modulation with spatial multiplexing over multiple antennas;
- Fig. 2: is a block diagram of a bit-interleaved coding and modulation encoder for spatial multiplexing;
- Fig. 3: shows the parity check matrix of an exemplary LDPC code with cyclic factor Q=8;
- Fig. 4: is a schematic illustration of the different robustness levels in a 8-PAM symbol with Gray encoding;
- Fig. 5A: is a block diagram of a 4-QAM (QPSK) constellation mapper;
- Fig. 5B: is a block diagram of a 16-QAM constellation mapper;
- Fig. 5C: is a block diagram of a 64-QAM constellation mapper;
- Fig. 6A: is a schematic representation of a spatial-multiplexing system with 2 antennas and a number of bits per SM block equal to 4 according to an embodiment of the present invention;
- Fig. 6B is: a schematic representation of a spatial-multiplexing system with 2 antennas and a number of bits per SM block equal to 6 according to an embodiment of the present invention;
- Fig. 6C is: a schematic representation of a spatial-multiplexing system with 2 antennas and a number of bits per SM block equal to 8 according to an embodiment of the present invention;
- Fig. 6D is: a schematic representation of a spatial-multiplexing system with 2 antennas and a number of bits per SM block equal to 10 according to an embodiment of the present invention;
- Fig. 7A is: a block diagram of one section of a bit interleaver for B = 4, according
- to: an embodiment of the present invention;
- Fig. 7B is: a block diagram of one section of a bit interleaver for B = 6, according
- to: an embodiment of the present invention;
- Fig. 7C is: a block diagram of one section of a bit interleaver for B = 8, according
- to: an embodiment of the present invention;
- Fig. 7D is: a block diagram of one section of a bit interleaver for B = 10, according to an embodiment of the present invention;
- Figs. 8A to 8D: show a more intuitive representation of the reordering performed by the bit interleavers of Figs. 7A to 7D, respectively;
- Figs. 9A to 9D: show specific configurations of the bit-interleaving coding and modulation encoder of Fig. 2 for B = 4, 6, 8, and 10, respectively; and
- Fig. 10: shows a schematic block diagram of a receiver according to an embodiment of the present invention.

### DETAILED DESCRIPTION

It is the particular approach of the present invention to provide a bit interleaver that ensures that (i) the Bt bits of each QAM symbol are mapped to exactly Bt/2 cyclic blocks of the quasi-cyclic LDPC codeword in such a way that each of the Bt/2 cyclic blocks is associated with bits of the same robustness, and (ii) that the T QAM symbols of a spatial-multiplexing (SM) block are mapped onto different cyclic blocks of the LDPC codeword. In other words, each constellation word is made up of bits from Bt/2 different cyclic blocks of the codeword, each pair of constellation word bits that have the same robustness is made up of bits from the same cyclic block, and constellation words for different antennas are made up of bits from different cyclic blocks. Hence, an SM block is made up of bits from B/2 cyclic blocks.

In a preferred embodiment of the present invention, the communication system employs square QAM constellations. Therefore, the number of bits per constellation word for antenna t, Bt, is always an even number and the two QAM components (real and imaginary part) are each modulated by the same number of bits, Bt/2.

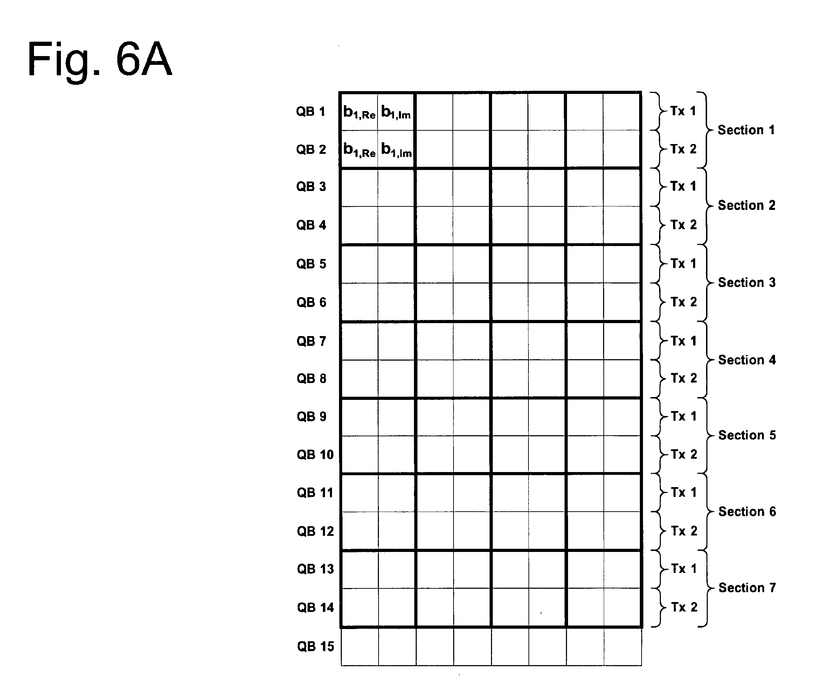

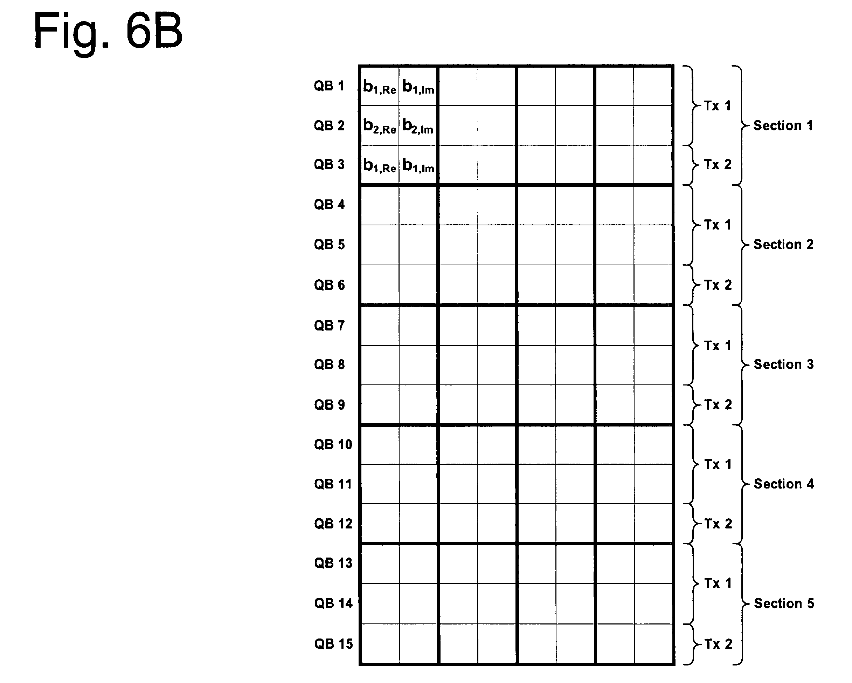

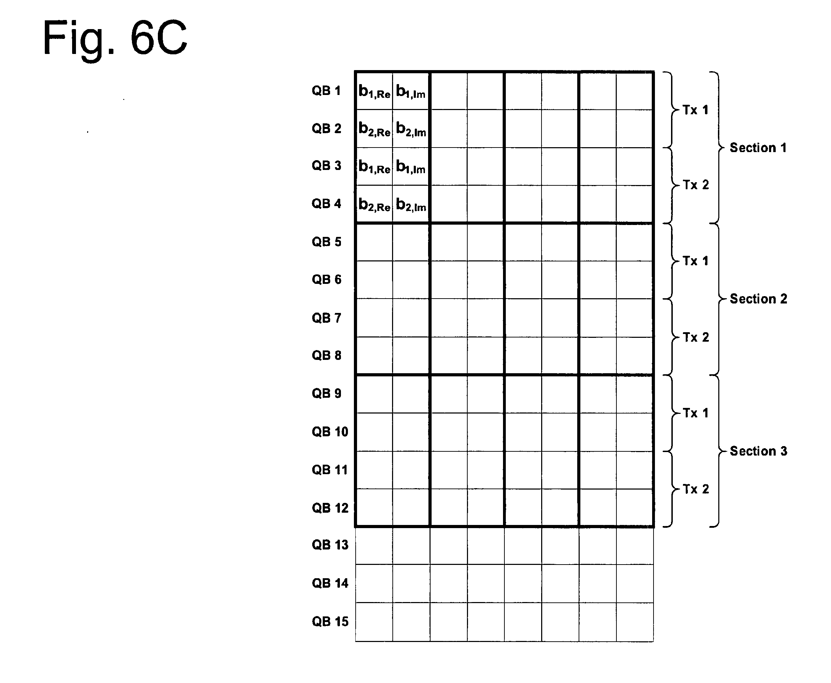

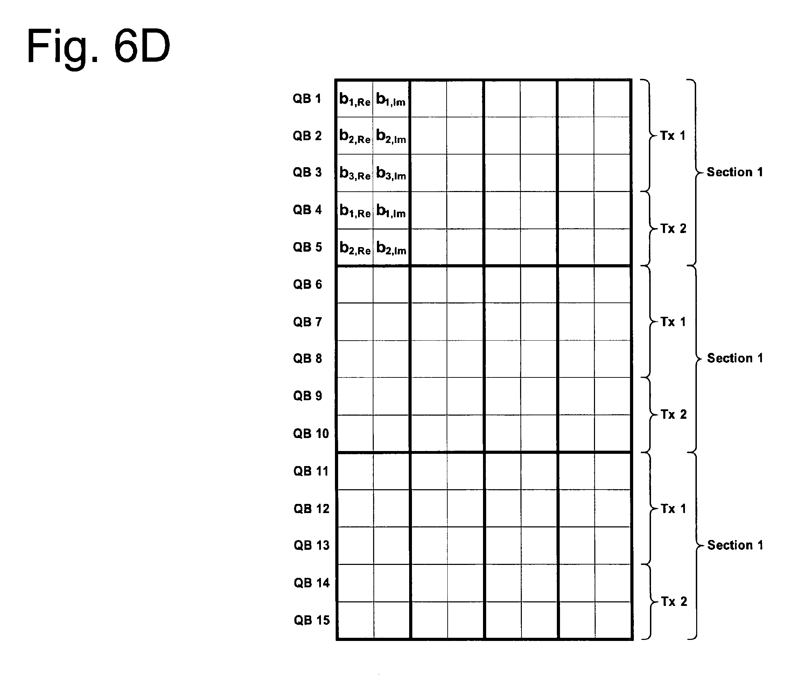

Preferably, the Q·B/2 bits of the B/2 cyclic blocks are mapped to Q/2 spatial-multiplexing blocks. In this case, the B/2 cyclic blocks are referred to as a section. Such a configuration is shown in Figs. 6A to 6D for a spatial-multiplexing system with 2 antennas and a number of bits per spatial-multiplexing block equal to 4, 6, 8, and 10 respectively. The thick borders group bits belonging to the same SM block. In these examples the LDPC parameters are: the cyclic factor Q = 8, and the number of cyclic blocks per codeword N = 15.

The mapping of the bits of a certain section to the corresponding constellation words may be performed independently of the other sections. This allows for a particularly efficient implementation, wherein a plurality of section permutation units are provided, one for each section, that are adapted for parallel operation. This implementation will be referred to as a parallel interleaver.

For the cases where N is not a multiple of B/2, i.e. B = 4 and 8 in the above examples, the codeword cannot be divided into sections of B/2 cyclic blocks each. Instead, there will be a "remainder" of 1 to B/2-1 cyclic blocks. The mapping for these remaining cyclic blocks is not a subject of the present invention. One option is to perform the mapping sequentially.

Moreover, the order of the N cyclic blocks is usually different from their order in the LDPC code definition, the order being defined by an N-element permutation.

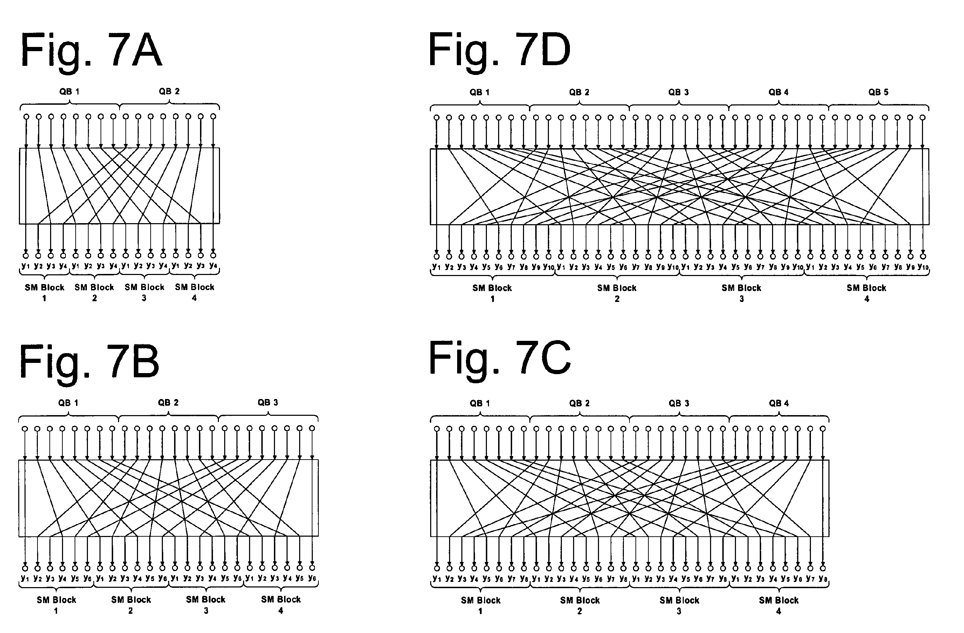

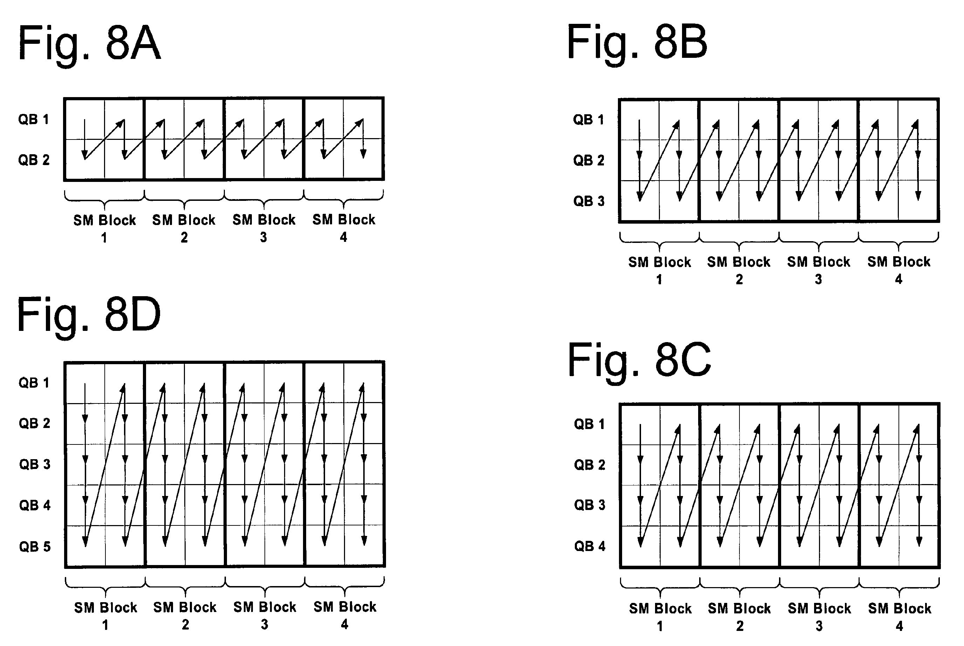

Figures 7A to 7D show one section of the parallel interleaver for B = 4, 6, 8, and 10 respectively, while Figures 8A to 8D show a more intuitive representation of the reordering performed by the bit interleaving for the same configurations. The number of cyclic blocks per interleaver section is 2, 3, 4, and 5 respectively.

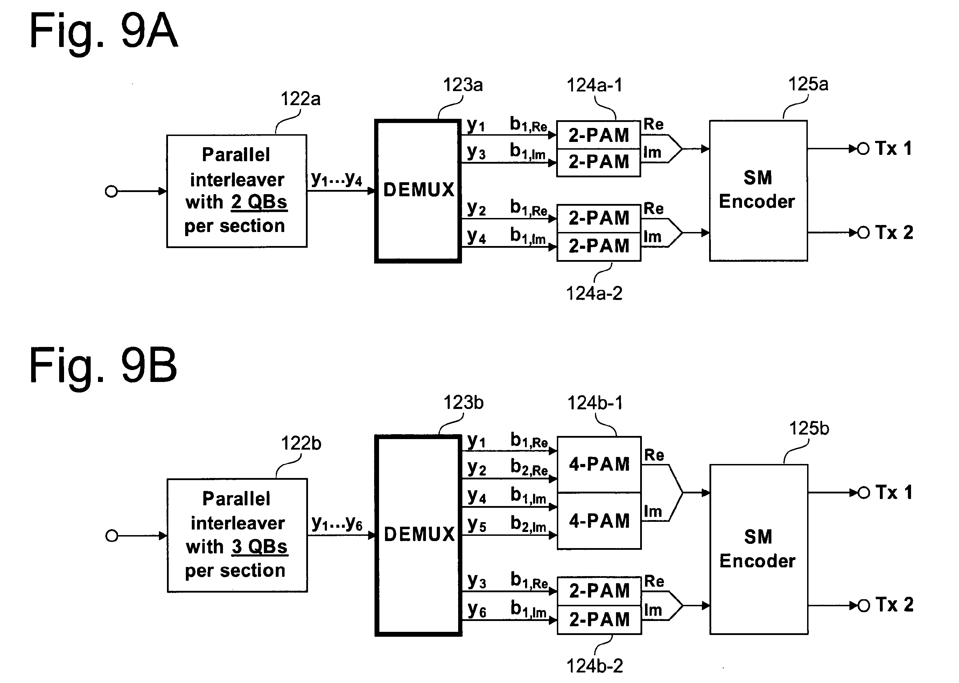

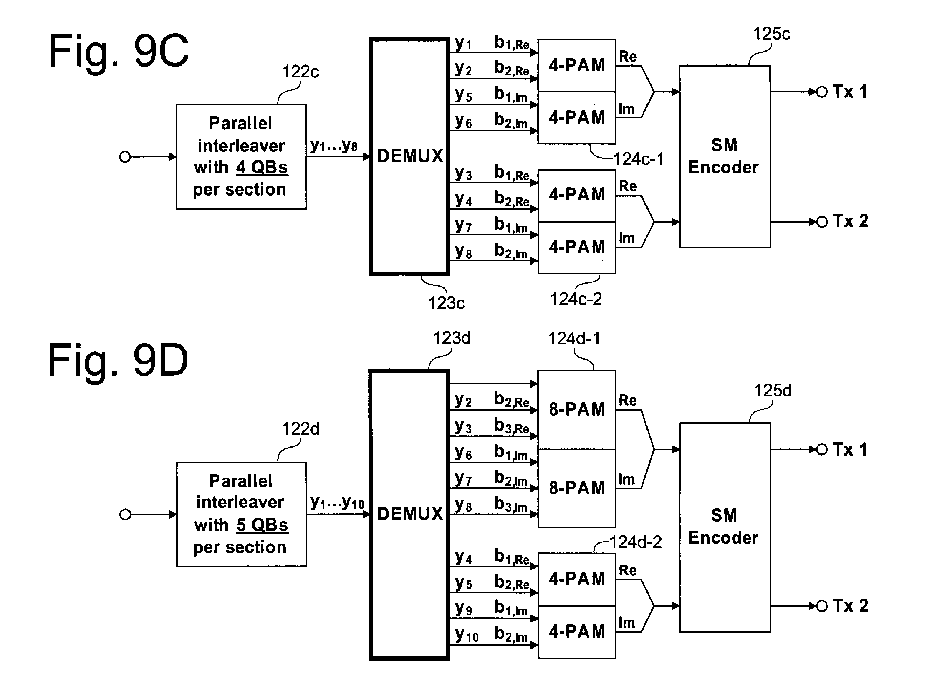

Figures 9A to 9D show specific configurations of the bit interleaver, demultiplexer, and QAM mapper pathway of the BICM encoder of Fig. 2 for B = 4, 6, 8, and 10, respectively. Specifically, the LDPC codeword generated by LDPC encoder 121 in Fig. 2 is fed to bit interleaver 122a, ..., 122d in Figs. 9A to 9d, respectively. The resulting permuted codeword is fed to demultiplexer 123a, ..., 123d in order to map the bits (y1...y4, ..., y1...y10) of the permuted codeword to the constellation words. The bits of each constellation word (b_{1,Re}, b_{1,Im}, ...) are then mapped to a complex symbol (Re, Im) by means of a pair of PAM mappers (124a-1, 124a-2; ...; 124d-1, 124d-2). The complex symbols may be subjected to a spatial multiplexing by means of an SM encoder (125a, ..., 125d) in order to generate the transmit signals Tx1 and Tx2.

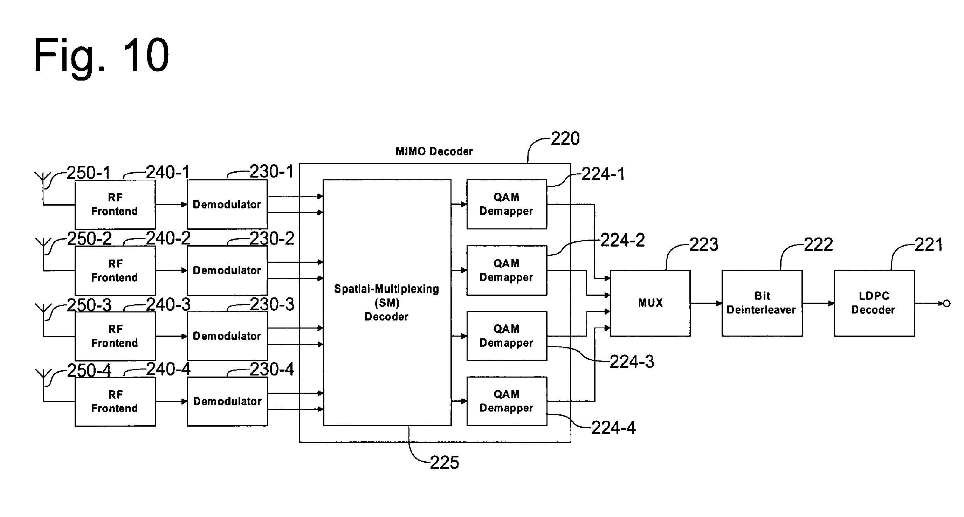

Figure 10 shows a schematic block diagram of a receiver according to an embodiment of the present invention. The receiver mirrors the functionality of the transmitter. A generic receiver has R receive antennas and receives the signal from the T transmit antennas. R and T are not necessarily the same.

The signal from each antenna (250-1, ..., 250-4) is processed by a radio-frequency RF frontend (240-1, ..., 240-4), typically comprising a tuner and a down-converter, and by a demodulator (230-1, ..., 230-4). For each receive antenna (250-1, ..., 250-4), the demodulator (230-1, ..., 230-4) produces for each channel slot one received symbol and T channel fading coefficients. The received symbols and the associated channel coefficients are complex valued. For each channel slot, the R received symbols and the TxR associated channel coefficients are provided as input to the spatial-multiplexing SM decoder (225), which produces T complex symbols at its output. These symbols then undergo QAM constellation demapping (224-1, ..., 224-4), multiplexing (223), bit de-interleaving (222) and LDPC decoding (221), i.e. the exact inverse steps in the transmitter as explained above in conjunction with Figs. 1 and 2.

The combination of SM decoding and QAM constellation demapping is sometimes referred in the art as multiple-input multiple-output (MIMO) decoding. In high-end implementations, a so-called maximum-likelihood decoding is employed, whereby the SM decoding and the QAM constellation demapping are performed jointly in one MIMO decoder block. These aspects are well known in the art.

Although the present invention has been illustrated by means of specific examples, it is not limited to their particulars, such as the number of antennas, the specific constellations, or any of the LDPC parameter values such as N and Q. In fact, the present invention may be applied to any number of antennas, including two, four, eight or any other number of antennas. The invention may also be applied to any QAM constellation, in particular to square QAM constellations, such as 4-QAM, 16-QAM, 64-QAM, 256-QAM, etc. The invention may also be applied to any LDPC code, in particular to those codes that are adopted for second-generation digital video broadcasting standards, such as DVB-S2, DVB-T2, and DVB-C2, as they are defined, for instance, in tables A.1 through A.6 of the DVB-T2 standard ETSI EN 302.755.

Further, the present invention is not restricted to a particular form for implementing the disclosed methods and devices, both in software or in hardware. Specifically, the invention may be implemented in form of a computer-readable medium having embodied thereon computer-executable instructions that are adapted for allowing a computer, a microprocessor, a microcontroller, and the like, to perform all steps of a method according to the embodiments of the present invention. The invention may also be implemented in form of an application-specific integrated circuit (ASIC) or in form of a field programmable gate array (FPGA).

Summarizing, the present invention relates to bit interleaving and de-interleaving of quasi-cyclic low-density parity-check (QC-LDPC) codes for a communication system with spatial multiplexing over a plurality of transmit antennas and discloses a bit interleaver and a corresponding method that achieves optimum diversity and allows for a particularly efficient hardware implementation due to its high degree of parallelism. To this end, a permutation for mapping the bits of the QC-LDPC codeword to a sequence of constellation words is constructed such that (i) each constellation word is made up of bits from Bt/2 different cyclic blocks of the codeword, Bt being the number of bits of the constellation word, (ii) each pair of constellation word bits that have the same robustness is made up of bits from the same cyclic block, and (iii) constellation words for different antennas are made up of bits from different cyclic blocks.

## Claims

1. A method for bit interleaving in a communication system with spatial multiplexing over T transmit antennas employing quasi-cyclic low-density parity-check codes, T being an integer greater than 1, the method comprising the steps of:
receiving a codeword of the quasi-cyclic low-density parity-check code, the codeword consisting of N cyclic blocks, each cyclic block consisting of Q bits;
applying a bit permutation to the bits of the codeword;
dividing the permuted codeword into a plurality of spatial-multiplexing blocks, each spatial-multiplexing block consisting of B bits partitioned into T constellation words, one for each transmit antenna, each constellation word indicating one of a plurality of predefined constellation points, the bits of each constellation word being divisible into pairs of bits having the same robustness,
**characterized in that** the bit permutation is adapted such that
there is at least one spatial-multiplexing block that is made up of bits from B/2 different cyclic-blocks; and
each constellation word of the at least one spatial-multiplexing block is made up of bits from Bt/2 different cyclic blocks, Bt being the number of bits of the constellation word, wherein each of the bit pairs of the constellation word is made up of bits from a common one of the Bt/2 different cyclic blocks.

2. A method according to claim 1, further comprising the step of
dividing the codeword into a plurality of sections such that either each section comprises B/2 cyclic blocks or one of the sections comprises less than B/2 cyclic blocks and each of the other sections comprises B/2 cyclic blocks;
wherein the bit permutation is adapted such that each spatial-multiplexing block is made up of bits from one section only.

3. A method according to claim 2, wherein the step of applying the bit permutation is performed by applying a section permutation to the bits of each section independently of the other sections.

4. A method according to any of claims 1 to 3, wherein the bit permutation is adapted such that all Q bits of a cyclic group are mapped to bits of the same robustness.

5. A method according to any of claims 1 to 4, wherein the predefined constellation points represent square QAM constellations.

6. A method for bit de-interleaving in a communication system with spatial multiplexing over T transmit antennas employing quasi-cyclic low-density parity-check codes, T being an integer greater than 1, the method comprising the steps of:
receiving a plurality of spatial-multiplexing blocks, each spatial-multiplexing block consisting of B bits partitioned into T constellation words;
multiplexing the received plurality of spatial-multiplexing blocks into a bit string; and
applying an inverse bit permutation to the bits of the bit string in order to recover a codeword of the quasi-cyclic low-density parity-check code,
wherein the inverse bit permutation is adapted for reverting the bit permutation performed by the bit interleaving method of claims 1 to 5.

7. A bit interleaver for a communication system with spatial multiplexing over T transmit antennas employing quasi-cyclic low-density parity-check codes, T being an integer greater than 1, bit interleaver comprising:
a bit permutation unit adapted for receiving a codeword of the quasi-cyclic low-density parity-check code, the codeword consisting of N cyclic blocks, each cyclic block consisting of Q bits,
for applying a bit permutation to the bits of the codeword, and
for dividing the permuted codeword into a plurality of spatial-multiplexing blocks, each spatial-multiplexing block consisting of B bits partitioned into T constellation words, one for each transmit antenna, each constellation word indicating one of a plurality of predefined constellation points, the bits of each constellation word being divisible into pairs of bits having the same robustness,
**characterized in that** the bit permutation is adapted such that
there is at least one spatial-multiplexing block that is made up of bits from B/2 different cyclic-blocks; and
each constellation word of the at least one spatial-multiplexing block is made up of bits from Bt/2 different cyclic blocks, Bt being the number of bits of the constellation word, wherein each of the bit pairs of the constellation word is made up of bits from a common one of the Bt/2 different cyclic blocks.

8. A bit interleaver according to claim 7, wherein the bit permutation unit is further adapted for dividing the codeword into a plurality of sections such that either each section comprises B/2 cyclic blocks or one of the sections comprises less than B/2 cyclic blocks and each of the other sections comprises B/2 cyclic blocks; and
wherein the bit permutation is adapted such that each spatial-multiplexing block is made up of bits from one section only.

9. A bit interleaver according to claim 8, wherein the bit permutation unit comprises a plurality of section permutation units adapted for applying a section permutation to the bits of each section independently of the other sections.

10. A bit interleaver according to any of claims 7 to 9, wherein the bit permutation is adapted such that all Q bits of a cyclic group are mapped to bits of the same robustness.

11. A bit interleaver according to any of claims 7 to 10, wherein the predefined constellation points represent square QAM constellations.

12. A bit de-interleaver for a communication system with spatial multiplexing over T transmit antennas employing quasi-cyclic low-density parity-check codes, T being an integer greater than 1, the bit de-interleaver comprising:
a bit permutation unit (222, 223) adapted for receiving a plurality of spatial-multiplexing blocks, each spatial-multiplexing block consisting of B bits partitioned into T constellation words, for multiplexing the received plurality of spatial-multiplexing blocks into a bit string, and for applying an inverse bit permutation to the bits of the bit string in order to recover a codeword of the quasi-cyclic low-density parity-check code,
wherein the inverse bit permutation is adapted for reverting the bit permutation performed by the bit interleaver of claims 7 to 11.

13. A transmitter for a communication system with spatial multiplexing over multiple antennas employing quasi-cyclic low-density parity-check codes, the transmitter comprising:
an encoder (121) for encoding input data by means of a low-density parity check code;
a bit interleaver (122, 123) according to any of claims 6 to 10 for bit interleaving the bits of a codeword generated by the encoder and for mapping the interleaved bits to a plurality of constellation words; and
a plurality of constellation mappers (124-1, ..., 124-4), each for mapping a constellation word of the plurality of constellation words to a complex symbol that is to be transmitted by a corresponding one of a plurality of transmit antennas (150-1, ..., 150-4).

14. A receiver for a communication system with spatial multiplexing over multiple antennas employing quasi-cyclic low-density parity-check codes, the transmitter comprising:
a mulitple-input multiple-output decoder (220) for converting signals from a plurality of receive antennas (250-1, ..., 250-4) into a plurality of constellation words, one for each transmit antenna (150-1, ..., 150-4);
a mulitplexer for mapping the bits of the constellation words to a bit string;
a bit de-interleaver (222, 223) according to claim 12 for de-interleaving the bits of the bit string in order to recover a codeword of the the low-density parity check code; and
a decoder (221) for decoding the recovered codeword.

15. A receiver according to claim 14, wherein the mulitple-input multiple-output decoder (220) comprises
a spatial-multiplexing decoder (225) for converting the signals from the plurality of receive antennas (250-1, ..., 250-4) into a plurality of complex symbols, one for each transmit antenna (150-1, ..., 150-4); and
a plurality of constellation demappers (224-1, ..., 224-4), each for mapping a complex symbol of the plurality of complex symbols to a corresponding one of the constellation words.
